(19) Europäisches Patentamt
European Patent Office
Office européen des brevets

(11) **EP 1 990 878 B1**

(12) **FASCICULE DE BREVET EUROPEEN**

(45) Date de publication et mention
de la délivrance du brevet:
**06.07.2011 Bulletin 2011/27**

(51) Int Cl.:
***H01S 5/12*** *(2006.01)*

(21) Numéro de dépôt: **08155839.7**

(22) Date de dépôt: **07.05.2008**

(54) **Laser semi-conducteur à contre-réaction répartie forte**

Halbleiterlaser mit starker, verteilter Rückkopplung

Semiconductor laser with strong distributed feedback

(84) Etats contractants désignés:
**CH DE FR GB LI SE**

(30) Priorité: **11.05.2007 FR 0703389**

(43) Date de publication de la demande:
**12.11.2008 Bulletin 2008/46**

(73) Titulaire: **THALES**
**92200 Neuilly sur Seine (FR)**

(72) Inventeurs:
- **Carras, Mathieu**
  **94250 Gentilly (FR)**
- **De Rossi, Alfredo**
  **75014 Paris (FR)**

(74) Mandataire: **Esselin, Sophie et al**
**Marks & Clerk France**
**Conseils en Propriété Industrielle**
**Immeuble " Visium "**
**22, avenue Aristide Briand**
**94117 Arcueil Cedex (FR)**

(56) Documents cités:
**EP-A- 0 877 454      EP-A- 1 137 133**

- **RAST A ET AL: "NEW COMPLEX-COUPLED DFB-LASER WITH A CONTACTED SURFACE GRATING FOR L = 1.55 MM" IEE PROCEEDINGS: OPTOELECTRONICS, INSTITUTION OF ELECTRICAL ENGINEERS, STEVENAGE, GB, vol. 142, no. 3, 1 juin 1995 (1995-06-01), pages 162-164, XP000520441 ISSN: 1350-2433**
- **ZHANG X ET AL: "GAAS/GAALAS INTEGRATED TWINGUIDE DFB BCRW LASERS WITH FIRST-ORDER CONTACTED SURFACE GRATING" ELECTRONICS LETTERS, IEE STEVENAGE, GB, vol. 28, no. 4, 13 février 1992 (1992-02-13), pages 422-424, XP000284767 ISSN: 0013-5194**
- **RAST A ET AL: "ROOM-TEMPERATURE CW OPERATION OF =1.55UM INGAAS/INP ITG-DFB-BCRW LASERS WITH CONTACTED SURFACE GRATING" ELECTRONICS LETTERS, IEE STEVENAGE, GB, vol. 27, no. 10, 9 mai 1991 (1991-05-09), pages 808-809, XP000230458 ISSN: 0013-5194**
- **RAST A: "A NOVEL INGAASP/INP DISTRIBUTED FEEDBACK LASER WITH A CONTACTED SURFACE GRATING FOR =1.55 M" ARCHIV FUR ELEKTRONIK UND UBERTRAGUNGSTECHNIK, S.HIRZEL VERLAG. STUTTGART, DE, vol. 43, no. 6, 1 novembre 1989 (1989-11-01), pages 388-389, XP000080268 ISSN: 0001-1096**

## Description

La présente invention concerne un laser semi-conducteur à contre-réaction répartie. Plus précisément, l'invention met en oeuvre un guide optique pour laser semi-conducteur possédant un réseau métallique de surface permettant d'obtenir une contre-réaction répartie stable et maîtrisée, selon une technologie simple et robuste.

Il est connu que le premier objectif de la contre-réaction répartie est d'éliminer au maximum les modes secondaires du laser. Un deuxième objectif est généralement de réduire les pertes miroir, c'est-à-dire les pertes dues à la longueur finie de la cavité du laser.

Actuellement, il existe deux technologies principales de réalisation de lasers à contre-réaction répartie, ou lasers DFB, pour Distributed FeedBack en anglais.

Ces deux technologies connues sont d'une part l'utilisation de réseaux enterrés, dans le but d'effectuer une modulation par l'indice, et d'autre part l'utilisation de réseaux métalliques de surface, dans le but d'effectuer une modulation par le gain.

La technologie qu'on appellera « des réseaux enterrés » consiste à graver un réseau périodique d'épaisseur en créneaux après la croissance de la zone active du laser semi-conducteur. Ensuite, la couche supérieure du guide du laser est réalisée par une nouvelle étape de croissance sur le réseau. Cette technologie introduit un couplage par l'indice car l'onde se propageant dans la zone active perçoit une modulation de l'indice effectif de la cavité qui évolue avec l'épaisseur. Elle permet d'obtenir une forte contre-réaction répartie dans dégrader le seuil du laser, c'est-à-dire sans introduire de perte supplémentaire.

Le principal inconvénient de cette technologie est qu'elle nécessite d'interrompre la croissance entre la zone active et le guide afin de graver le réseau puis de réaliser une nouvelle étape de croissance par épitaxie. Cette étape est technologiquement difficile à réaliser, notamment parce qu'il faut effectuer une épitaxie sur le réseau, donc sur une surface non parfaitement plane. De plus, les performances de la contre-réaction répartie sont très sensibles au profil de la gravure du réseau dans la couche semi-conductrice proche de la zone active ; toute variation de la profondeur de gravure influe en effet directement sur le coefficient de couplage du réseau. Ceci rend la contre-réaction difficile à maîtriser.

La seconde technologie connue permettant de réaliser des lasers à contre-réaction répartie est celle « des réseaux de surface métallisés ». Cette technologie permet de réaliser un couplage par le gain (ou couplage par les pertes). Il s'agit ici de réaliser la croissance de toutes les couches du laser : zone active, guides et couches de contact. Un motif est ensuite gravé dans le guide supérieur, puis métallisé. Par rapport à la technologie des réseaux enterrés, cette technologie présente l'avantage que les étapes introduisant la contre-réaction répartie, en particulier la gravure du motif dans le guide supérieur, sont réalisées après la croissance de toutes les couches. Elle est donc plus simple à mettre en oeuvre. En revanche, son principal défaut est que la contre-réaction répartie est obtenue par modulation des pertes. Ceci introduit des pertes supplémentaires, ce qui augmente le seuil du laser et dégrade donc ses performances. De plus, la contre-réaction répartie est, comme pour la technologie des réseaux enterrés, difficile à maîtriser car très sensible à la précision du motif gravé. Enfin, la contre-réaction répartie obtenue est également liée aux pertes optiques introduites par le métal et les matériaux constitutifs du guide, ce qui constitue un autre paramètre difficile à maîtriser.

En résumé, les technologies existantes permettant de mettre au point des lasers à contre-réaction répartie sont en général difficiles à mettre en oeuvre et à maîtriser et peuvent dégrader les performances du laser. Il est à noter cependant que l'on cherche de manière préférentielle à privilégier les lasers à modulation d'indice qui présentent, malgré une mise en oeuvre délicate, des pertes moindres que dans les lasers à modulation des pertes.

Dans ce contexte, la présente invention propose un nouveau type de laser à contre-réaction répartie par modulation de l'indice et de technologie plus aisée que celles de l'art connu. Ainsi, la technologie qui va être décrite ci-après permet la réalisation de lasers à contre-réaction répartie forte ; elle est simple à mettre en oeuvre technologiquement et à maîtriser, et n'affecte pas les performances du laser.

A cet effet, l'invention a pour objet un laser semi-conducteur comportant au moins :

- un substrat assurant la fonction de support mécanique,
- une zone active présentant un premier indice de réfraction intrinsèque $n1$ et un indice de réfraction effectif $neff$, dans laquelle peut se propager une onde lumineuse possédant une longueur d'onde $\lambda$ destinée à laser,
- un guide supérieur présentant un deuxième indice de réfraction intrinsèque $n2$ et une épaisseur $d$, et, en surface, une structure de réseau au moins partiellement recouverte d'une couche de matériau dont la permittivité diélectrique présente une partie réelle négative, comme par exemple du métal, ledit réseau présentant une période $\Lambda$ et une profondeur $P$,
- un guide inférieur présentant un troisième indice de réfraction intrinsèque $n3$,
  caractérisé en ce que :
- la profondeur $p$ dudit réseau est comprise entre environ $\left[ 0,5 \times \dfrac{\lambda}{4 \times neff} \right]$ et environ $\left[ 1,5 \times \dfrac{\lambda}{4 \times neff} \right]$, de manière à introduire une modulation de l'indice effectif de la zone active permettant d'obtenir une contre-réaction répartie stable et maîtrisée.

Avantageusement, le guide supérieur est réalisé dans un matériau semi-conducteur intrinsèque ou faiblement dopé de manière à introduire une variation de l'indice de réfraction intrinsèque du matériau constitutif dudit guide supérieur inférieure à environ dix pourcents.

Avantageusement, le laser comprend en outre une fine couche de matériau semi-conducteur fortement dopé à la surface du guide supérieur assurant une fonction de contact ohmique.

Avantageusement, la couche fortement dopée possède une épaisseur pouvant être inférieure à environ 100 nm.

Avantageusement, la profondeur du réseau périodique est d'environ 0,5 $\mu$m.

Avantageusement, le substrat est réalisé en InP, ou en GaAs, ou en GaSb, ou en InAs, ou en Si.

Avantageusement, le guide inférieur est réalisé dans un matériau semi-conducteur fortement dopé.

Avantageusement, le guide inférieur est réalisé en InP. Avantageusement, le guide supérieur est réalisé en InP, ou en InGaAs, ou en AlGaAs.

Avantageusement, la zone active est un empilement de fines couches, GaAs et AlGaAs, ou AlInAs et GaInAs, ou InAs et AlSb.

D'autres caractéristiques et avantages de l'invention apparaîtront à l'aide de la description qui suit faite en regard des dessins annexés qui représentent :

- la figure 1 : l'illustration schématique d'un premier exemple de laser selon l'invention ;
- la figure 2 : le schéma d'un second exemple de laser selon l'invention ;
- la figure 3 : le spectre d'un laser réalisé selon l'invention ;
- la figure 4 : la courbe de l'évolution des pertes des modes de bord de bande du laser en fonction de la profondeur p du réseau périodique gravé ;
- la figure 5 : la courbe de l'évolution du coefficient de couplage K en fonction de la profondeur p du réseau périodique gravé.

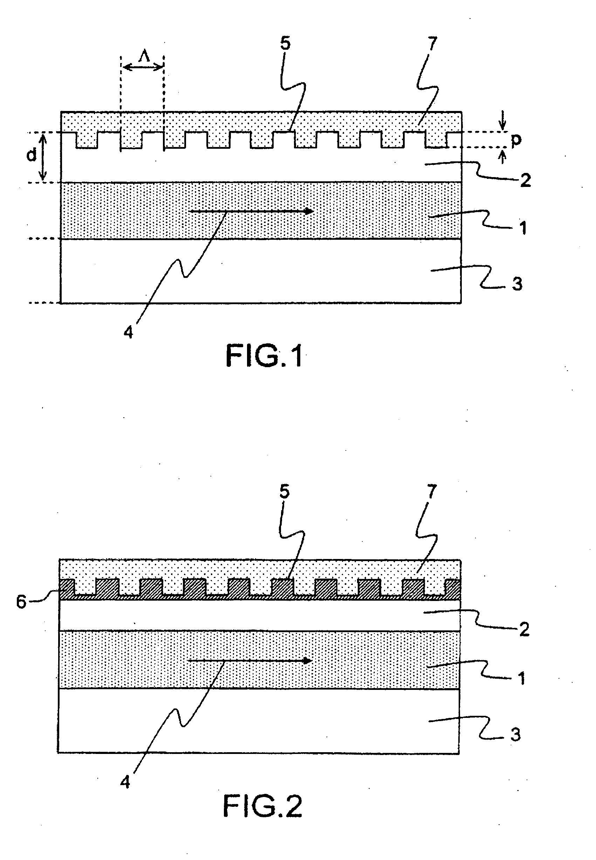

La figure 1 présente un schéma simplifié du laser selon l'invention. Le point clé réside dans la compréhension des phénomènes physiques qui se produisent dans le laser et à leur maîtrise.

En effet, dans le laser selon l'invention, grâce à un empilement adéquat des couches constituant la zone active 1, et grâce à un guide supérieur 2 constitué d'un matériau semi-conducteur non dopé ou faiblement dopé (c'est-à-dire introduisant une variation de l'indice de réfraction inférieure à 10%), on obtient un couplage entre les ondes de surface, également appelés plasmons, de la structure métallique 7 qui recouvre le réseau 5 situé en haut du guide supérieur 2 et les modes guidés par les couches semiconductrices 2 et 3. Ce couplage introduit une modulation de l'indice sans perte supplémentaire. Ce phénomène physique est décrit dans le document M. CARRAS et A. DE ROSSI « Photonic modes of metallodielectric periodic waveguides in the midinfrared spectral range », Physical Review B, 74,235120 (2006). Par ailleurs, le brevet français 2 893 184 décrit une utilisation des propriétés des plasmons de surface dans le cadre d'une structure optique de localisation d'un champ électromagnétique. Pour être efficace, le réseau périodique 5 gravé en surface du guide supérieur 2 du laser doit avoir une profondeur p appropriée, d'environ $\left[\dfrac{\lambda}{4 \times neff}\right]$, pour une onde lumineuse 4 se propageant à la longueur d'onde $\lambda$ dans la zone active 1 du laser présentant un indice de réfraction effectif neff.

La figure 2 illustre un second exemple de laser selon l'invention. Cet autre exemple est très proche de celui de la figure 1 mais il intègre en outre une très fine couche de matériau fortement dopé 6 à la surface du guide supérieur 2. Cette couche assure uniquement la fonction de contact ohmique. Il s'agit là d'une différence majeure d'avec les lasers actuels comportant un réseau de surface métallique. En effet, ces derniers possèdent généralement une épaisse couche diélectrique fortement dopée, dite « couche plasmon », permettant d'optimiser le couplage par pertes. Dans le laser selon l'invention, cette « couche plasmon » est absente et sa présence serait même pénalisante.

Au contraire, si le laser selon l'invention peut préférentiellement mais non obligatoirement contenir une couche de matériau diélectrique fortement dopé 6, celle-ci doit être très fine, d'une épaisseur de l'ordre de ou inférieure à 100 nm.

Dans ce cas, le réseau périodique 5 est gravé dans la couche de matériau diélectrique fortement dopé 6, le bas des créneaux pouvant ou non atteindre la couche non dopée constituant la base du guide supérieur 2 (sur la figure 2, à titre d'exemple, les créneaux restent contenus dans la couche 6).

Le laser selon l'invention permet donc de réaliser un couplage par l'indice, en s'affranchissant de la technologie des réseaux enterrés, c'est-à-dire sans nécessiter de reprise de croissance par épitaxie. Par ailleurs, aucune perte supplémentaire n'est introduite contrairement à ce qui se produit avec les lasers actuels comportant un réseau de surface métallique.

Exemple de réalisation.

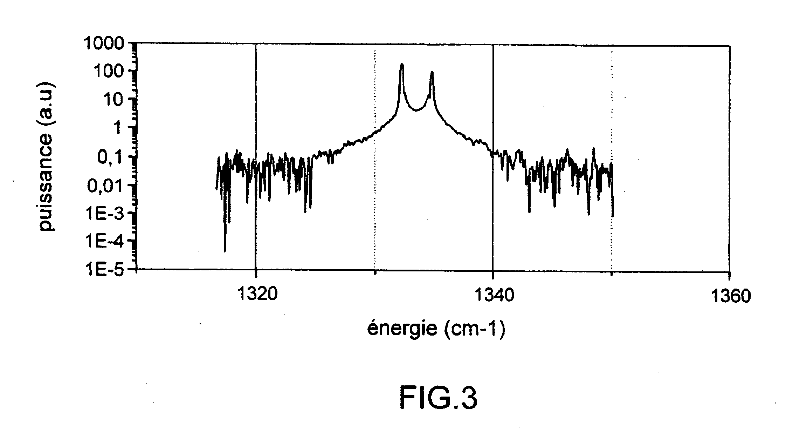

La figure 3 représente le spectre d'un laser selon l'invention. Dans cet exemple, conforme au schéma de la figure 1, le réseau périodique 5, gravé en surface du guide supérieur 2 et métallisé, présente une profondeur d'environ 0,5 $\mu$m et une période d'environ 1,25 $\mu$m.

L'onde lumineuse 4 lase à une longueur d'onde d'environ 8 μm. Les guides inférieur 3 et supérieur 2 sont en InP non dopé et la zone active est constituée d'un empilement de fines couches AlInAs et GaInAs.

Dans ces conditions, le spectre laser de la figure 3 fait apparaître deux pics centrés sur les longueurs d'onde de bord de la bande interdite. Il s'agit des deux modes prépondérants de ce laser ; les pertes sont équivalentes sur les deux modes, ce qui montre bien que l'on a réalisé une modulation de l'indice effectif de la zone active 1.

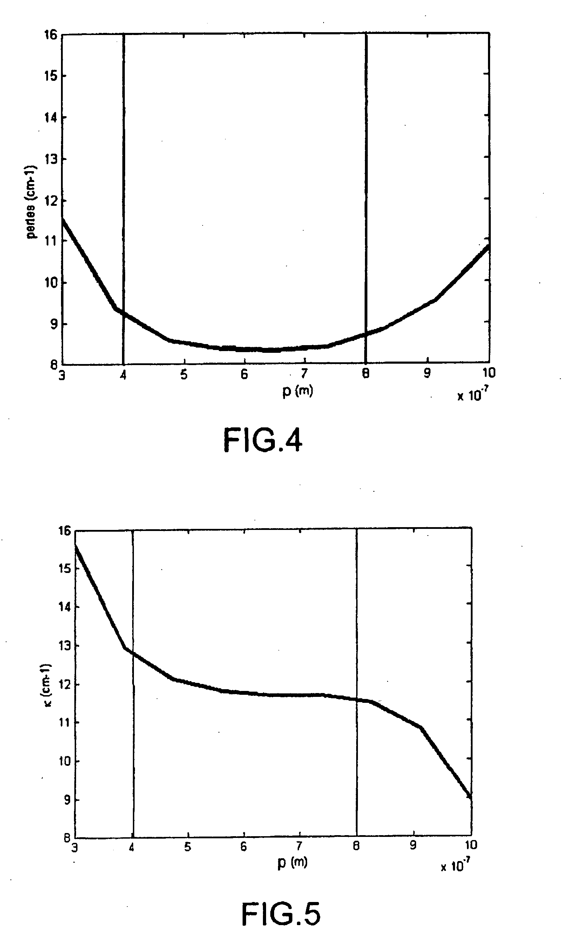

Les figures 4 et 5 illustrent la robustesse de la technologie de réalisation de lasers à contre-réaction répartie (ou lasers DFB) selon l'invention, et en particulier la faible dépendance du coefficient de couplage du réseau K vis-à-vis de la précision de gravure de la profondeur p du réseau périodique 5. Pour réaliser ces courbes, des réseaux périodiques 5 de différentes profondeurs p ont été gravés à la surface du guide supérieur 2 de lasers selon l'invention tels que schématisés dans la figure 1. Systématiquement, les guides inférieur 3 et supérieur 2 étaient en InP, et la zone active 1 était un empilement de fines couches AlInAs et GaInAs. La période du réseau 5 est d'environ 1,25 μm et la longueur d'onde de l'onde lumineuse (4) est d'environ 8 μm.

La figure 4 met en avant le fait que les pertes d'un des modes guidés ne varient quasiment pas pour une profondeur p du réseau 5 variant de 0,4 μm à 0,8 μm ; ce qui constitue, concernant la profondeur p, une précision de gravure facile à atteindre avec les machines standards actuelles.

La figure 5 démontre que le coefficient de couplage K varie d'à peine 10% sur la même plage de variation de la profondeur p du réseau 5.

En revanche, afin de contrôler le coefficient de couplage K du réseau, on peut noter que ce dernier est plus élevé lorsque l'épaisseur du guide supérieur est plus faible, et réciproquement.

En résumé, l'invention a pour principal avantage de permettre la réalisation technologiquement facile à mettre en oeuvre et à maîtriser de lasers à contre-réaction répartie (ou lasers DFB) par modulation d'indice.

## Revendications

1. Laser semi-conducteur comportant au moins :

    • un substrat assurant la fonction de support mécanique,
    • une zone active (1) présentant un premier indice de réfraction intrinsèque (n1) et un indice de réfraction effectif (neff), dans laquelle se propage une onde lumineuse (4) possédant une longueur d'onde (λ) destinée à laser,
    • un guide supérieur (2) présentant un deuxième indice de réfraction intrinsèque (n2) et une épaisseur (d), et, en surface, une structure de réseau (5) au moins partiellement recouverte d'une couche de matériau (7) dont la permittivité diélectrique présente une partie réelle négative, comme par exemple du métal, ledit réseau (5) présentant une période (Λ) et une profondeur (p),
    • un guide inférieur (3) présentant un troisième indice de réfraction intrinsèque (n3),

    la profondeur (p) dudit réseau (5) étant comprise entre environ

    $$\left[ 0,5 \times \frac{\lambda}{4 \times neff} \right] \text{ et environ}$$

    $$\left[ 1,5 \times \frac{\lambda}{4 \times neff} \right],$$

    **caractérisé en ce que** le guide supérieur (2) est réalisé dans un matériau semi-conducteur intrinsèque non dopé ou comprenant une fine couche dopée (6) dont le dopage introduit une variation de l'indice optique inférieure à dix pourcents, et **en ce que** ladite fine couche dopée (6) présente une épaisseur inférieure à 100nm, de sorte qu'il se produit une modulation de l'indice effectif de la zone active (1) engendrant une contre-réaction stable et maîtrisée.

2. Laser selon la revendication 1, **caractérisé en ce que** la profondeur (p) du réseau périodique (5) est d'environ 0,5 μm.

3. Laser selon l'une quelconque des revendications précédentes, **caractérisé en ce que** le substrat est réalisé en InP, ou en GaAs, ou en GaSb, ou en InAs, ou en Si.

4. Laser selon l'une quelconque des revendications précédentes, **caractérisé en ce que** le guide inférieur (3) est réalisé dans un matériau semi-conducteur fortement dopé.

5. Laser selon l'une quelconque des revendications précédentes, **caractérisé en ce que** le guide inférieur (3) est réalisé en InP.

6. Laser selon l'une quelconque des revendications précédentes, **caractérisé en ce que** le guide supérieur (2) est réalisé en InP, ou en InGaAs, ou en AlGaAs.

7. Laser selon l'une quelconque des revendications précédentes, **caractérisé en ce que** la zone active (1) est un empilement de fines couches :

    • GaAs et AlGaAs,
    • ou AlInAs et GaInAs,
    • ou InAs et AlSb.

**Claims**

1. A semi-conductor laser comprising at least:

   • a substrate providing a mechanical support function,
   • an active zone (1) having a first intrinsic refraction index (n1) and an effective refraction index (neff), wherein a light wave (4) having a wavelength (λ) designed for lasing propagates,
   • an upper guide (2) having a second intrinsic refraction index (n2) and a thickness (d) and, on the surface, a grating structure (5) at least partially covered with a layer of material (7), the dielectric permittivity of which has a real negative component, such as, for example, of metal, said grating (5) having a period (A) and a depth (p),
   • a lower guide (3) having a third intrinsic refraction index (n3),

   the depth (p) of said grating (5) being between approximately $\left[ 0{,}5 \times \frac{\lambda}{4 \times neff} \right]$ and approximately $\left[ 1{,}5 \times \frac{\lambda}{4 \times neff} \right]$,

   **characterised in that** said upper guide (2) is made from an intrinsic non-doped semi-conductor material or comprises a thin doped layer (6) the doping of which introduces a variation in the optical index of less than ten percent, and **in that** said thin doped layer (6) has a thickness of less than 100nm, such that a modulation of the effective index of the active zone (1) is produced resulting in stable and controlled feedback.

2. The laser according to claim 1, **characterised in that** the depth (p) of the periodic grating (5) is approximately 0.5 μm.

3. The laser according to any one of the preceding claims, **characterised in that** the substrate is made from InP or from GaAs or from GaSb or from InAs or from Si.

4. The laser according to any one of the preceding claims, **characterised in that** the lower guide (3) is made from a highly doped semi-conductor material.

5. The laser according to any one of the preceding claims, **characterised in that** the lower guide (3) is made from InP.

6. The laser according to any one of the preceding claims, **characterised in that** the upper guide (2) is made from InP or from InGaAs or from AlGaAs.

7. The laser according to any one of the preceding claims, **characterised in that** the active zone (1) is a stack of thin layers:

   • GaAs and AlGaAs,
   • or AlInAs and GaInAs,
   • or InAs and AlSb.

**Patentansprüche**

1. Halbleiterlaser, der wenigstens Folgendes umfasst:

   • ein Substrat, das eine mechanische Stützfunktion bietet,
   • eine aktive Zone (1) mit einem ersten intrinsischen Brechungsindex (n1) und einem effektiven Brechungsindex (neff), wobei sich eine Lichtwelle (4) mit einer zum Lasern geeigneten Wellenlänge (λ) ausbreitet,
   • eine obere Führung (2) mit einem zweiten intrinsischen Brechungsindex (n2) und einer Dicke (d) und einer Gitterstruktur (5) auf der Oberfläche, die wenigstens teilweise mit einer Materialschicht (7) bedeckt ist, deren dielektrische Leitfähigkeit eine reale negative Komponente wie z.B. aus Metall hat, wobei das Gitter (5) eine Periode (A) und eine Tiefe (p) hat,
   • eine untere Führung (3) mit einem dritten intrinsischen Brechungsindex (n3),

   wobei die Tiefe (p) des Gitters (5) zwischen etwa $\left[ 0{,}5 \times \frac{\lambda}{4 \times neff} \right]$ und etwa $\left[ 1{,}5 \times \frac{\lambda}{4 \times neff} \right]$ liegt,

   **dadurch gekennzeichnet, dass** die obere Führung (2) aus einem intrinsischen nichtdotierten Halbleitermaterial gefertigt ist oder eine dünne dotierte Schicht (6) umfasst, deren Dotierung eine Variation des optischen Index von weniger als zehn Prozent bewirkt, und **dadurch**, dass die dünne dotierte Schicht (6) eine Dicke von weniger als 100 nm hat, so dass eine Modulation des effektiven Index der aktiven Zone (1) erzeugt wird, die ein stabiles und geregeltes Feedback ergibt.

2. Laser nach Anspruch 1, **dadurch gekennzeichnet, dass** die Tiefe (p) des periodischen Gitters (5) etwa 0,5 μm beträgt.

3. Laser nach einem der vorherigen Ansprüche, **dadurch gekennzeichnet, dass** das Substrat aus InP oder aus GaAs oder aus GaSb oder aus InAs oder aus Si gefertigt ist.

4. Laser nach einem der vorherigen Ansprüche, **dadurch gekennzeichnet, dass** die untere Führung (3) aus einem hoch dotierten Halbleitermaterial gefertigt ist.

5. Laser nach einem der vorherigen Ansprüche, **dadurch gekennzeichnet, dass** die untere Führung (3) aus InP gefertigt ist.

6. Laser nach einem der vorherigen Ansprüche, **dadurch gekennzeichnet, dass** die obere Führung (2) aus InP oder aus InGaAs oder aus AlGaAs gefertigt ist.

7. Laser nach einem der vorherigen Ansprüche, **dadurch gekennzeichnet, dass** die aktive Zone (1) ein Stapel von dünnen Schichten ist:

   • GaAs und AlGaAs,
   • oder AlInAs und GaInAs,
   • oder InAs und AlSb.

FIG.1

FIG.2

FIG.3

EP 1 990 878 B1

FIG.4

FIG.5

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2893184

**Littérature non-brevet citée dans la description**

- **M. CARRAS ; A. DE ROSSI.** Photonic modes of metallodielectric periodic waveguides in the midinfrared spectral range. *Physical Review B,* 2006, vol. 74, 235120